Europäisches Patentamt

European Patent Office

Office européen des brevets

(11) Publication number: **0 341 312 B1**

# EUROPEAN PATENT SPECIFICATION

(45) Date of publication of patent specification: **23.06.93**

(51) Int. Cl.5: **C01G 3/00**, **H01B 13/00**, **H01B 12/06**, **H01L 39/12**

(21) Application number: **88908374.7**

(22) Date of filing: **28.09.88**

(86) International application number:
**PCT/JP88/00986**

(87) International publication number:
**WO 89/02872 (06.04.89 89/08)**

(54) **PASTE FOR FORMING SUPERCONDUCTIVE CERAMIC FILM.**

(30) Priority: **29.09.87 JP 246957/87**

(43) Date of publication of application:
**15.11.89 Bulletin 89/46**

(45) Publication of the grant of the patent:
**23.06.93 Bulletin 93/25**

(84) Designated Contracting States:
**DE FR GB**

(56) References cited:
**EP-A- 0 292 125**

**NEW ELECTRONICS, vol. 20, no. 10, 12th May 1987, page 30, London, GB; P. JUDGE: "Superconductor future heats up"**

**APPLIED PHYSICS LETTERS, vol. 51, no. 16, 19th October 1987, pages 1277-1279, American Institute of Physics, New York, US; R.C. BUDHANI et al.: "Synthesis of superconducting films of the Y-Ba-Cu-O system by a screen printing method"**

(73) Proprietor: **MITSUBISHI MATERIALS CORPORATION**
**6-1, Otemachi 1-chome**
**Chiyoda-ku Tokyo(JP)**

(72) Inventor: **MORI,Satoru Mitsubishi Kinzoku K.K.**
**Chuo Kenkyujo**
**297, Kitabukurocho 1-chome**
**Omiya-shi Saitama 330i Saitama 330(JP)**
Inventor: **YOSHIDA,Hideaki Mitsub. K.K.K.**
**Chuo Kenkyujo**
**297,Kitabukurocho 1-chome**
**Omiya-shi Saitama 330(JP)**
Inventor: **TAKESHITA,Takuo Mitsubishi K.K.K.**
**Chuo Kenkyujo**
**297, Kitabukurocho 1-chome**
**Omiya-shi Saitama 330(JP)**
Inventor: **KANDA, Yoshio Mitsubishi K.K.K.**
**Chuo Kenkyujo**
**297,Kitabukurocho 1-chome**
**Omiya-shi Saitama 330(JP)**

Applied Physics letters, Vol. 51, No. 11, (14 September 1987) B. OH, et al (Critical curent densities and transport in superconducting Y Ba2Cu307- films made by electron beam coevaporation)

Denshi zairyo, Vol. 26, No. 8, August 1987 (Tokyo) Yamanaka Kazunori and one other (Alumina Kiban jo no Chodendo Haisen Gijutsu)

(74) Representative: **Glawe, Delfs, Moll & Partner Patentanwälte Postfach 26 01 62 Liebherrstrasse 20 W-8000 München 26 (DE)**

## Description

TECHNICAL FIELD

This invention relates to a superconducting ceramic film and, more particularly, to a paste used for formation of a superconducting ceramic film capable of maintaining a high critical temperature under large electric current densities.

BACKGROUND ART

A typical example of the superconducting ceramic films printed on various kinds of substrate is disclosed by Hideomi Koinuma et al in " High Tc Superconductivity in Screen Printed Yb-Ba-Cu-O Films ", Japanese Journal of Applied Physics, Vol. 26, No. 5, May 1987, pages L761 to L762. For forming the superconducting ceramic films, two powders with respective nominal compositions of $(Yb_{0.25}Ba_{0.75})_3Cu_3O_{9-\delta}$ ( which is referred to as powder A ) and $(Yb_{0.32}Ba_{0.68})_3Cu_3O_{9-\delta}$ ( which is referred to as powder B ) were prepared by mixing the prescribed amounts of $Yb_2O_3$, $BaCO_3$ and $CuO$ in ethanol, calcining to form a dried mixture at 900 degrees in centigrade for 12 hours, pulverizing the calcined product, then further calcining the powder at 900 degrees in centigrade for 2 days to produce the powder B. The powder B was mixed into hepthyl alcohol to produce a paste which was printed on several kinds of substrate through a 150 mesh silk screen. After being dried in vacuo, the paste was sintered in air at 900 degrees in centigrade for 0.5 to 5 hours to produce a superconducting ceramic films. Koinuma et al reported in the paper that the superconductive ceramic films had shown zero resistivities at high temperatures. Namely, one of the specimens had a temperature of zero resistivity as high as 77.2 degrees in Kelvin under an electric current density of 0.02 ampere/cm$^2$, but when the electric current density was increased to 14.2 amperes/cm$^2$, the superconducting ceramic film merely showed the zero resistivity at 15.8 degrees in Kelvin. Thus, the paste disclosed by Koinuma has a drawback in critical temperature under large electric current densities.

It is therefore an important object of the present invention to provide a paste used in a screen printing which results in a superconducting ceramic film capable of maintaining a high critical temperature under a large electric current density.

DISCLOSURE OF INVENTION

To accomplish these objects, the present invention proposes to mix a powder of an alkaline earth metal carbonate into a powder of superconducting oxide.

In accordance with the present invention, there is provided a paste used for printing a superconducting film on a substrate, comprising: a) a first powder of an oxygen compound containing at least one element selected from the group consisting of scandium, yttrium and lathanides, at least one element selected from the group consisting of alkaline earth metals, and copper; and b) a second powder of an alkaline earth metal carbonate. The oxygen compound may be selected from the group consisting of $(LaBa)_2CuO$, $(LaSr)_2CuO$, $(LaCa)_2CuO$, $YBa_2Cu_3O_{6.5}$, $LuBa_2Cu_3O_{6.5}$, $YbBa_2Cu_3O_6$, $TmBa_2Cu_3O_{6.5}$, $ErBa_2Cu_3O_{6.5}$, $DyBa_2Cu_3O_{6.4}$, $TbBa_2Cu_3O_{6.3}$, $GdBa_2Cu_3O_{6.5}$, $EuBa_2Cu_3O_{6.5}$, $SmBa_2Cu_3O_{6.5}$ and $LaBa_2Cu_3O_7$. On the other hand, the alkaline earth metal carbonate may be selected from the group consisting of $BaCO_3$, $SrCO_3$ and $CaCO_3$. In an implementation, the alkaline earth metal carbonate has a proportion ranging between about 0.1 % and about 10.0 % by weight with respect to the paste. The paste is allowed to contain an organic vehicle which may be selected from the group consisting of ethyl cellulose, butyl carbitol acetate and a mixture thereof. The oxygen compound may contain a plurality of elements selected from the group consisting of scandium, yttrium and lathanides, a plurality of elements selected from the group consisting of alkaline earth metals and copper.

The inventors discover that a carbonate affects a superconducting oxide upon the sintering process and, accordingly, improves the electric current density thereof. Particularly, an alkaline earth metal carbonate does not react with the superconducting oxide, so that the alkaline earth metal carbonate is the most preferable additive to improve the electric current density of the superconducting ceramic material without the sacrifice of the critical temperature or the temperature of zero resistivity.

Experimental results are shown in Table I in which a powder of an alkaline earth metal carbonate is added to a powder of a superconducting oxide to form a paste for printing on a substrate, then sintering the paste, thereby obtaining each of samples No. 1 to 14. However, samples No. 15 to 19 are formed without the powder of alkaline earth metal carbonate. Each sintering temperature and each period of time are shown in Table II.

3

Comparing the samples No. 1 to 14 with the samples No. 15 to 19, it is understood that relatively high critical temperatures are maintained even if the electric current densities are increased. This is because of the fact that the powder of the alkaline earth metal carbonate is mixed into the powder of superconducting oxide.

Table I

| No. | Oxide powder | Carbonate (WT%) | Critical temp. (K) | Current density (A/cm$^2$) |
|---|---|---|---|---|
| 1 | $(LaBa)_2CuO$ | $BaCO_3$ (0.1) | 35 | 200 |
| 2 | $(LaSr)_2CuO$ | $SrCO_3$ (2.0) | 39 | 500 |
| 3 | $(LaCa)_2CuO$ | $CaCO_3$ (1.5) | 33 | 650 |
| 4 | $YBa_2Cu_3O_{6.5}$ | $BaCO_3$ (1.0) | 91 | 750 |
| 5 | $LuBa_2Cu_3O_{6.5}$ | $BaCO_3$ (1.0) | 89 | 940 |
| 6 | $YbBa_2Cu_3O_6$ | $BaCO_3$ (2.0) | 91 | 850 |
| 7 | $TmBa_2Cu_3O_{6.5}$ | $BaCO_3$ (5.0) | 90 | 370 |
| 8 | $ErBa_2Cu_3O_{6.5}$ | $BaCO_3$ (1.5) | 85 | 530 |
| 9 | $DyBa_2Cu_3O_{6.4}$ | $BaCO_3$ (10.0) | 87 | 490 |
| 10 | $TbBa_2Cu_3O_{6.3}$ | $BaCO_3$ (10.0) | 85 | 660 |
| 11 | $GdBa_2Cu_3O_{6.5}$ | $BaCO_3$ (2.0) | 84 | 550 |
| 12 | $EuBa_2Cu_3O_{6.5}$ | $BaCO_3$ (1.0) | 90 | 420 |
| 13 | $SmBa_2Cu_3O_{6.5}$ | $BaCO_3$ (1.0) | 81 | 320 |
| 14 | $LaBa_2Cu_3O_7$ | $BaCO_3$ (1.0) | 82 | 230 |
| 15 | $(LaBa)_2CuO$ | None | 40 | 0.009 |

| | | | |
|---|---|---|---|
| 16 $YBa_2Cu_3O_{6.5}$ | None | 91 | 0.02 |
| 17 $YbBaCu_3O_6$ | None | 93 | 0.01 |
| 18 $TmBa_2Cu_3O_{6.5}$ | None | 91 | 0.02 |
| 19 $DyBa_2Cu_3O_{6.4}$ | None | 87 | 0.01 |

Table II

| No. | Sintering Temp. ( in Kelvin scale ) | Sintering Time ( hour ) |
|---|---|---|
| 1 | 1123 | 2 |
| 2 | 1123 | 2 |
| 3 | 1123 | 2 |
| 4 | 1173 | 2 |
| 5 | 1123 | 2.5 |
| 6 | 1173 | 1 |
| 7 | 1123 | 1 |
| 8 | 1173 | 3 |
| 9 | 1173 | 3 |
| 10 | 1073 | 4 |
| 11 | 1173 | 2 |
| 12 | 1173 | 2 |
| 13 | 1173 | 3 |
| 14 | 1123 | 2 |
| 15 | 1123 | 2 |
| 16 | 1173 | 2 |
| 17 | 1173 | 1 |
| 18 | 1123 | 1 |
| 19 | 1173 | 3 |

BEST MODE FOR CARRYING OUT THE INVENTION

First, a superconducting ceramic material of an oxygen compound, an alkaline earth metal carbonate and an organic vehicle are prepared to form a paste. The oxygen compound is represented by the molecular formula of $YBa_2Cu_3O_{6.5}$, and the alkaline earth metal carbonate is represented by the molecular formula of $BaCO_3$. The organic vehicle is formed by mixing ethyl cellulose into butyl carbitol acetate and is proportioned to ethyl cellulose-butyl carbitol acetate ratio 1:4.

The oxygen compound and the alkaline earth metal carbonate are respectively pulverized to form a first powder of the oxygen compound and a second powder of the alkaline earth metal carbonate, and the first and second powders are sifted by using a 325 mesh screen. The first and second powders are mixed into the organic vehicle to form the paste which contains about 81.5 % of the oxygen compound, about 8.5 % of the alkaline earth metal carbonate and 10 % of the organic vehicle by weight.

The paste thus prepared is printed on a top surface of an yttrium stabilized zirconia substrate through a 250 mesh screen in Japanese Mesh Screen Standard to form a thin film, and the printed film is dried in air, then being further dried in a high temperature ambient at about 125 degrees in centigrade for about 10 minutes. The yttrium stabilized zirconia substrate is manufactured by Toyo Soda Corporation and has a generally square-shaped top surface measuring about 25 mm x 25 mm. The yttrium stabilized zirconia

EP 0 341 312 B1

substrate has a thickness of about 1 mm.

Then, the yttrium stabilized zirconia substrate with the printed film is placed in a high temperature ambient of about 930 degrees in centigrade for about 4 hours, thereby forming a superconducting ceramic film on the yttrium stabilized zirconia substrate. The superconducting ceramic film is a generally rectangular shape measuring about 20 mm x about 10 mm and having a thickness of about 15 micrometers.

The resistivity and its temperature dependence are measured by the dc four probe method. The superconducting ceramic film stays in the superconducting state and the critical temperature or the temperature of zero resistivity as high as about 91 degrees in Kelvin is achieved. When the electric current density is increased to about 750 amperes/ cm$^2$, no substantial difference takes place in the critical temperature.

Preferred modes of carrying out the invention are described in the claims.

## INDUSTRIAL APPLICATION

As described hereinbefore, the paste used for formation of a superconducting ceramic film is useful in formation of a superconducting ceramic film. Moreover, the paste is used in a screen printing process. The superconducting ceramic film thus formed is capable of keeping a high critical temperature even if the current density is increased.

## Claims

1. A paste used for printing a superconducting film on a substrate, comprising:
   a) a first powder of an oxygen compound containing at least one element selected from the group consisting of scandium, yttrium and lathanides, at least one element selected from the group consisting of alkaline earth metals, and copper; and
   b) a second powder of an alkaline earth metal carbonate.

2. A paste as set forth in claim 1, in which an alkaline earth metal used for forming said alkaline earth metal carbonate is identical with said element selected from the group consisting of alkaline earth metals used for forming said first powder.

3. A paste as set forth in claim 2, in which said alkaline earth metal carbonate has a proportion ranging between about 0.1 % and about 10.0 % by weight with respect to said paste.

4. A paste used for printing a superconducting film on an yttrium stabilized zirconia substrate , comprising:
   a) a first powder of an oxygen compound represented by the molecular formula of $YBa_2Cu_3O_{6.5}$ which is about 81.5 % by weight with respect to said paste;
   b) a second powder of an alkaline earth metal carbonate represented by the molecular formula of $BaCO_3$ which is about 8.5 % by weight with respect to said paste; and
   c) an organic vehicle containing about 2 % of ethyl cellulose and about 8 % of butyl carbitol acetate by weight with respect to said paste, said first and second powders being mixed into said organic vehicle.

## Patentansprüche

1. Paste zum Aufdrucken eines supraleitfähigen Films auf Substrat, umfassend:
   a) ein erstes Pulver aus einer Sauerstoffverbindung, die mindestens ein Element aus der Gruppe Scandium, Yttrium und Lathanide, mindestens ein Element aus der Gruppe der Erdalkalimetalle, und Kupfer enthält, und
   b) ein zweites Pulver aus einem Erdalkalimetall-Carbonat.

2. Paste nach Anspruch 1, bei dem das zur Bildung des Erdalkalimetall-Carbonats verwendete Erdalkalimetall identisch ist mit dem zur Bildung des ersten Pulvers aus der Gruppe der Erdalkalimetalle ausgewählte Element.

3. Paste nach Anspruch 2, bei der das Erdalkalimetall-Carbonat in einem Anteil zwischen ca. 0,1 Gew.-% und ca. 10,0 Gew.-% im Bezug auf die Paste vorliegt.

6

**4.** Paste für das Aufdrucken eines supraleitfähigen Films auf ein Substrat aus yttrium-stabilisiertem Zirkoniumoxyd, umfassend

a) ein erstes Pulver aus einer Sauerstoffverbindung mit der Molekularformel $YBa_2Cu_3O_{6.5}$ die ca. 81,5 Gew.-% der Paste ausmacht;

b) ein zweites Pulver aus einem Erdalkalimetall-Carbonat der Molekularformel $BaCO_3$, die etwa 8,5 Gew.-% der Paste ausmacht; und

c) ein organisches Bindemittel, das ca. 2 Gew.-% Ethylcellulose und ca. 8 Gew.-% Butylcarbitolacetat bezüglich der Paste enthält, wobei das erste und zweite Pulver in das Bindemittel eingemischt sind.

**Revendications**

**1.** Pâte utilisée pour l'impression d'un film supraconducteur sur un substrat, comportant :

a) une première poudre d'un composé oxygéné contenant au moins un élément choisi dans le groupe constitué du scandium, de l'yttrium et des lanthanides, au moins un élément choisi dans le groupe constitué des métaux alcalino-terreux, et du cuivre ; et

b) une deuxième poudre d'un carbonate d'un métal alcalino-terreux.

**2.** Pâte selon la revendication 1, dans laquelle un métal alcalino-terreux utilisé pour former ledit carbonate d'un métal alcalino-terreux est identique audit élément choisi dans le groupe constitué des métaux alcalino-terreux et utilisé pour former ladite première poudre.

**3.** Pâte selon la revendication 2, dans laquelle ledit carbonate d'un métal alcalino-terreux est présent dans une proportion allant de 0,1% environ à 10% environ, en poids en se référant à ladite pâte.

**4.** Pâte utilisée cour l'impression d'un film supraconducteur sur un substrat en zircone stabilité à l'yttrium, comportant :

a) une première poudre d'un composé oxygéné représenté par la formule moléculaire $YBa_2Cu_3O_{6,5}$, présente dans la proportion de 81,5% en environ, en poids en se référant à ladite pâte ;

b) une deuxième poudre d'un carbonate d'un métal alcalino-terreux représenté par la formule moléculaire $BaCO_3$, présente dans la proportion de 8,5% environ, en poids en se référant à ladite pâte ; et

c) un véhicule organique contenant 2% environ d'éthylcellulose et 8% environ de butyle-carbitol, en poids en se référant à ladite pâte, ladite première poudre et ladite deuxième poudre étant mélangées dans ledit véhicule organique.